# EUROPEAN PATENT APPLICATION

(11) **EP 4 760 774 A1**
(43) Date of publication of application: **17.06.2026**
(21) Application number: 25184010.4
(22) Date of filing: 19.06.2025
(51) Int. Cl.: H01J 37/32, H01L 21/3065

(54) **A METHOD OF PLASMA ETCHING**

(30) Priority: 10.12.2024 GB 202418088
(71) Applicant: SPTS Technologies Limited, NP18 2TA (GB)
(72) Inventor: Burman, Tristan, Newport, NP18 2TA (GB)
(74) Representative: Wynne-Jones IP Limited

(57) **Abstract**

There is disclosed a method of plasma etching a workpiece. The method comprises the steps of: placing the workpiece upon a substrate support within a plasma chamber, wherein the workpiece comprises a SiC substrate; introducing SF₆, O₂ and He process gases into the plasma chamber; plasma etching the SiC substrate to thereby reduce surface roughness of the SiC substrate by alternating between: (i) applying a bias RF power to the substrate support to generate a reactive-ion etching plasma in the plasma chamber, and etching the SiC substrate at a first plasma chamber pressure for a first period of time; and (ii) applying a source RF power to the plasma chamber to generate an inductively coupled plasma in the plasma chamber and applying a bias RF power to the substrate support, and etching the SiC substrate at a second plasma chamber pressure for a second period of time.

## Description

### Background

Silicon Carbide (SiC) is a wide bandgap semiconductor material that is becoming increasingly common in many applications from power electronics, to integrated optics, and quantum technology. Additionally, thanks to its high-temperature, high-power, and high-radiation tolerances, SiC is an excellent material choice for environments where other materials simply cannot perform.

In order to manufacture these devices a number of complex, often very thin material layers must be epitaxially grown on the bulk SiC wafers. SiC can also be used as a substrate for the growth of other III-V materials such as Gallium Nitride (GaN) or Aluminium Nitride (AIN). This is particularly desirable when the costs for a given material substrate are particularly high.

Therefore, in order to achieve a high-quality epitaxial growth, and high-performance devices, it is vital that the SiC surface is as close to perfectly atomically smooth as possible. In practice in a manufacturing environment the surface roughness Ra should be ~1nm. In power devices specifically it has been shown that the substrate surface roughness itself has a measurable impact on the end device performance.

SiC wafers are cut from a large ingot and then undergo lapping followed by a mechanical or chemical mechanical polish.. Defects on the polished surface can propagate though the epitaxial layers and result in "killer defects" which can cause device failure or even longer term reliability problems. Novel surface treatment steps which can address surface roughness and defects are therefore required to reduce costly yield losses.

K. Kanarik et al: Atomic Layer Etching: Rethinking the Art of Etch, The Journal of Physical Chemistry Letters, Vol 9/Issue 16, describes SiC surface smoothing using plasma processes resulting in an 83% reduction in root mean square roughness.

The work used an Atomic Layer Etching (ALE) approach using a Cl/Ar chemistry and pulsed platen power. A drawback of the process demonstrated is its slowness. The process required 200 etch cycles. Each cycle removed only 0.067 nm, close to the theoretical limit of 0.068 nm. As each cycle took 12 seconds this process takes over 40 minutes per wafer with a material removal rate of 0.02µm/hour.

GB2601041 describes preparing a SiC wafer for epitaxial growth via plasma processing on an ICP tool. Six plasma processes are disclosed which aim to smooth the surface of SiC. All of the processes use some Hydrogen component, which was found to be important for the smoothing. The six processes disclosed were found to reduce roughness from between 34% to 84% with the most successful using a HBr/O₂/SF₆ chemistry with a ratio of 4:1:1.

A. Osipov et al: High-temperature etching of SiC in SF6/O2 inductively coupled plasma, Nature 2020, discloses an SF₆/O₂ plasma etch capable of etching trenches into SiC surfaces at high temperatures. A 92% reduction in root mean square surface roughness in the trenches was observed when platen temperature was elevated to 300°C. The high platen temperatures are a requirement for this process as temperatures between approximately 15°C and 250°C are reported to have caused an increase in surface roughness.

There is therefore a need in the art for a plasma based surface preparation process which overcomes the above drawbacks. In particular, there is a need for a cost-effective method of smoothing a SiC wafer to <1nm after mechanical polishing to support the epitaxial growth of SiC films with reduced defectivity to result in more reliable SiC devices.

### Summary

In a first aspect of the invention there is provided a method of plasma etching a workpiece, the method comprising the steps of: placing the workpiece upon a substrate support within a plasma chamber, wherein the workpiece comprises a SiC substrate; introducing SF₆, O₂ and He process gases into the plasma chamber; plasma etching the SiC substrate to thereby reduce surface roughness of the SiC substrate by alternating between: (i) applying a bias RF power to the substrate support to generate a reactive-ion etching (RIE) plasma in the plasma chamber, and etching the SiC substrate at a first plasma chamber pressure for a first period of time; and (ii) applying a source RF power to the plasma chamber to generate an inductively coupled plasma (ICP) in the plasma chamber and applying a bias RF power to the substrate support, and etching the SiC substrate at a second plasma chamber pressure for a second period of time.

The inventors have found that etching in a cyclical process, with a first RIE etch followed by a second ICP etch advantageously reduces the surface roughness of SiC substrate workpieces to a sub-nm surface roughness (i.e. <1nm) without using atomic layer etching techniques which tend to be time intensive. Helium was found to be especially beneficial for reducing surface roughness compared with heavier inert gases.

Furthermore, the claimed process allows for a shorter smoothing process in comparison to RIE-only or ICP-only methods because there is no need for any pre-etch argon treatment, as described herein.

Advantageously, the process may be hydrogen gas free. Advantageously, the process may be chlorine gas free.

The process may preferably be performed prior to epitaxial growth.

The first plasma chamber pressure may be over an order of magnitude greater than the second plasma chamber pressure.

The first plasma chamber pressure may be between 100-400 mTorr, for example about 200 mTorr.

The second plasma chamber pressure may be between 2-10 mTorr, for example about 5 mTorr.

Preferably, the second period of time is greater than the first period of time.

The first period of time may be between 5-60 seconds, for example between 10-20 seconds.

The second period of time may be between 20-120 seconds, for example between 40-50 seconds.

The substrate support may be maintained at a temperature between 10-50 degrees Celsius. Advantageously the method may enable variation of platen temperature without degrading the smoothing performance.

The substrate support may be maintained at a temperature between 15-25 degrees Celsius. The process may advantageously avoid high platen temperatures. The lower platen temperature is beneficial to materials and devices with lower thermal budgets or where wafer bonding material is being used.

During step (ii) the source **RF** power may be in the range of 1000-3000 W.

During step (i) the bias **RF** power may be in the range of 100-500 W.

During step (ii) the bias **RF** power may be in the range of 300-1000 W.

There may be a pause when looping between steps (i) and (ii) during which time the plasma chamber pressure may be adjusted between the first and second plasma chamber pressures, whilst nil source **RF** power and bias **RF** power is applied.

The pause may be for a few seconds, for example 2-10 seconds, optionally 5 seconds.

During step (ii), the bias RF power may be applied a few seconds, for example 2-10 seconds, optionally 5 seconds, after the source RF power is applied.

The SF₆, O₂ and He process gases are introduced to the plasma chamber at flow rates respectively between 40-60 sccm, 10-20 sccm and 90-110 sccm.

Prior to introducing SF₆, O₂ and He process gases into the plasma chamber, there may be a step of introducing Ar gas into the plasma chamber and applying a bias RF power to the substrate support to generate a reactive-ion etching plasma in the plasma chamber.

Optionally, during step (i) a nil source RF power is applied.

Optionally, during step (i) a source RF power of less than 500 Watts is applied.

In a second aspect of the invention there is provided an inductively coupled plasma apparatus for plasma etching a workpiece, the apparatus comprising: a plasma chamber; a platen assembly disposed within the plasma chamber configured to receive the workpiece, wherein the workpiece comprises a SiC substrate; a gas delivery system for introducing process gases into the plasma etch chamber; a plasma generation device for sustaining a plasma within the plasma chamber for etching the SiC substrate; a controller configured to control the apparatus to perform a plasma etch of the SiC substrate to reduce surface roughness of the SiC substrate by alternating between the steps of: (i) applying a bias RF power to the substrate support to generate a reactive-ion etching plasma in the plasma chamber whilst applying a nil source RF power, and etching the SiC substrate at a first plasma chamber pressure for a first period; and (ii) applying a source RF power to the plasma chamber to generate an inductively coupled plasma in the plasma chamber and applying a bias RF power to the substrate support, and etching the SiC substrate at a second plasma chamber pressure for a second period.

In a third aspect of the invention there is provided a method of plasma etching a workpiece, the method comprising the steps of: placing the workpiece upon a substrate support within a plasma chamber, wherein the workpiece comprises a SiC substrate; introducing SF₆, O₂ and He process gases into the plasma chamber; applying a source RF power to the plasma chamber to generate an inductively coupled plasma in the plasma chamber; applying a bias RF power to the substrate support; and etching the SiC substrate to thereby reduce surface roughness of the SiC substrate.

Whilst the high pressure RIE etch of the first and second aspects advantageously speeds up the ICP etching process and improves the surface uniformity, the inventors have appreciated that it can be omitted and yet there are still advantages to using SF₆, O₂ and He process gases in an ICP etching process. Such a process is free from hydrogen, and using He provides optimal results in comparison to use of heavier inert gases such as Ar.

### Drawings

An example embodiment of the invention will now be described by way of example only with reference to the following schematic figures:
Figures 1 and 2 are side views of an example inductively coupled plasma apparatus for plasma etching a workpiece;
Figure 3 is a flow diagram of a method of plasma etching the workpiece;
Figure 4 shows source RF power, bias RF power and chamber pressure as a function of time during the method of plasma etching the workpiece;
Figure 5 shows power spectral density data for the method of plasma etching the workpiece in comparison to a number of different test processes.

### Specific Description

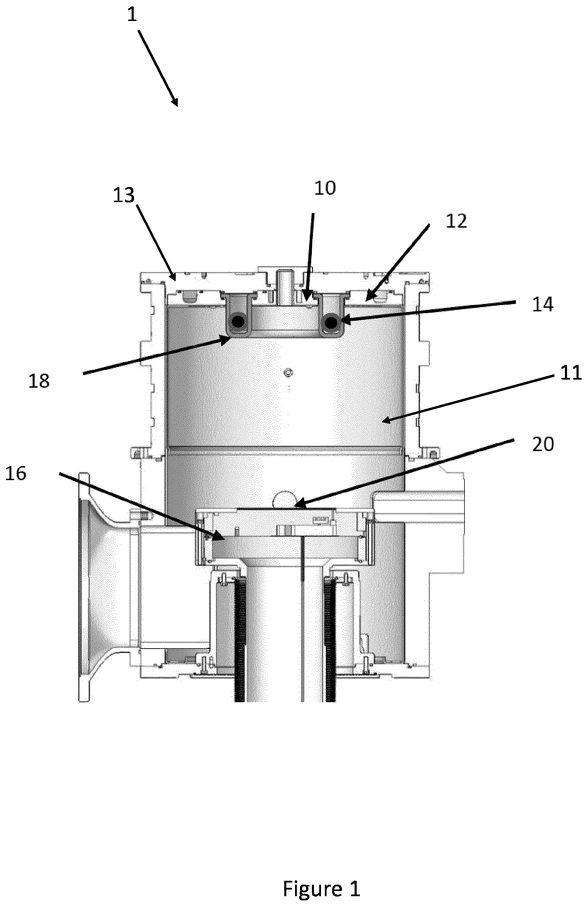

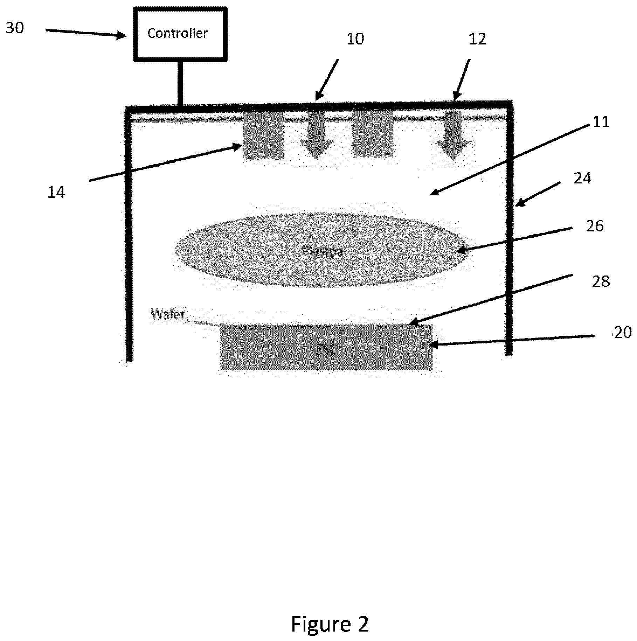

An inductively coupled plasma apparatus 1 according to the example embodiment is illustrated in Figures 1 and 2. The invention may be performed in an adapted version of the Applicant's Omega^{®} Synapse^{™} etch process module. Well known features such as the exhaust gas pumping system are not shown in Figures 1 and 2 but will be well understood by the skilled reader.

The apparatus 1 comprises a plasma etch chamber 11 having a plurality of internal surfaces. The apparatus comprises a first gas inlet arrangement 10, a second gas inlet arrangement 12, a ceramic annular housing 18, an RF antenna 14, a platen RF electrode 16 and a substrate support 20 for supporting a workpiece (i.e. a structure) 28 undergoing etching. In the embodiment shown in Figures 1 and 2, the substrate support 20 is an electrostatic chuck. The platen RF electrode 16 is used to control the directionality of the etch ions. This in turn controls the extent of physical etching of the workpiece achieved during processing. Higher platen powers will increase the etch rate. The electrostatic chuck is arranged with Helium backside cooling which is used to regulate the temperature of the wafer.

The plasma etch chamber 11 comprises an upper wall or lid 13. The annular housing 18 is immersed within the chamber 11 and depends downwardly from the upper wall. The annular housing 18 defines a circular region on the interior of the upper wall.

In the example embodiment shown in Figures 1 and 2, the first gas inlet arrangement 10 is an inner gas plenum and the second gas inlet arrangement 12 is an outer gas plenum. Each gas inlet arrangement comprises a plurality of gas inlets, each gas inlet terminating in an opening through which process gases enter the interior of the chamber 11. The inner plenum 10 sits within the circular region defined by the annular housing 18. The gas inlets of the inner gas plenum 10 are positioned inwardly of the annular housing 18 as a plurality of openings disposed in a circular pattern. The outer plenum 12 is positioned outside the circular region defined by the annular housing 18. The gas inlets of the outer gas plenum 10 are positioned outwardly of the annular housing 18 as a plurality of openings disposed in a circular pattern. The inner gas plenum can have eight gas inlets whereas the outer gas plenum may have about 10 times as many gas inlets. However, it will be appreciated that the first and second gas inlet arrangements can have any suitable number of gas inlets. Mass flow regulators (not shown) are coupled to the gas inlet arrangements and are used to control the flow of gases through to the chamber 11.

The etch chamber 11 is further illustrated in Figure 2, which illustrates processing of a workpiece 28 present in the chamber. The chamber comprises one or more chamber walls 24 within which the workpiece 28 is placed on the substrate support 20. A plasma 26 is ignited and sustained in the chamber 11 by RF power coupled into the chamber from an RF power source (not shown) via the RF antenna 14 (i.e. coil) contained within the annular housing 18. In the example embodiment the RF power source is a high frequency generator operating at 13.56 MHz. The platen RF electrode is driven at the same frequency from a separate power supply. The annular housing 18 acts as a window which allows RF power to be coupled into the chamber. Etch process gases comprising SF₆, O₂ and He gases enter the chamber 11 through the gas inlets of the inner gas plenum 10 and the outer gas plenum 12. A controller 30 is used to control the cyclical etch process. As part of its operation, the controller 30 can control the flow of the etch process gases into the chamber 11.

In the example embodiment, the workpiece 28 is a 150mm wafer comprising a SiC substrate (although other wafer sizes such as 100mm or 200mm are within the scope of the invention). In the example embodiment the SiC substrate has a thickness of 300-500 µm.

In the example embodiment of the invention, the method of plasma etching the workpiece comprises a first step of placing 101 the workpiece upon the substrate support within the plasma chamber. The workpiece is placed onto the electrostatic chuck and then clamped at 10-35 degrees Celsius. A transfer robot is used to place the workpiece onto the electrostatic chuck in the chamber under vacuum.

In a second step SF₆, O₂ and He process gases are introduced 103 (for example simultaneously) via the mass flow regulators into the plasma chamber. The SF₆, O₂ and He gases enter the plasma chamber at gas flow rates of approximately 40-60 sccm, 10-20 sccm and 80-120 sccm respectively, until the target pressure is achieved, in the example embodiment ~200 mTorr (between 100-400 mTorr).

Target pressure can be maintained by adjustment of the pumping speed and/or by adjusting the mass flow regulators. Subsequently, the SiC substrate is plasma etched in a cyclical process alternating between two etching modes.

In the first mode (RIE etch mode), a bias RF power is applied 105 to the substrate support to generate a reactive-ion etching plasma in the plasma chamber. The plasma is generated in the vicinity of the substrate support. A nil source RF power may be applied during this mode, or alternatively a low source RF power in the range 0-500 Watts may be applied. The SiC substrate is etched in a directional etch by RIE etching for a first, shorter, duration of time for example 5-60 seconds. In the first mode, the chamber is maintained at a first, higher, pressure in the example embodiment of about 200 mTorr. At the end of the first duration of time, the bias RF power is switched off 107 and the RIE plasma is extinguished.

After the first duration of time has elapsed, there is a first intermediate period. The chamber pressure is reduced 109 to a second, lower, pressure of about ~2-10 mTorr by varying the flow of the process gases into the chamber, in preparation for the ICP etch. In the example embodiment this intermediate step lasts for around 5 seconds (it being desirable for reasons of efficiency to minimise the duration of the power-off state).

After the first intermediate period, etching in the second mode commences. In the second mode (ICP etch mode), a source RF power is applied 111 to the plasma chamber to generate an inductively coupled plasma in the plasma chamber. After a short delay in which the ICP plasma is established, in the example embodiment of around 5 seconds, a bias RF power is applied to the substrate support (or alternatively the power supplies may be applied at the same time). The SiC substrate is etched through ICP etching for a second, longer, duration of time for example 20-120 seconds. In the second mode, the chamber is maintained at the second, lower, pressure for the duration of the ICP etching. After the second duration of time has elapsed, both power sources are switched off 113 (for example simultaneously) and the ICP plasma is extinguished.

After the second duration has elapsed, there is a second intermediate period. The chamber pressure is increased back up to the first, higher, pressure (by varying the flow of the process gases into the chamber) in preparation for the RIE etch. In the example embodiment this intermediate step lasts for around 5 seconds (it being desirable for reasons of efficiency to minimise the duration of the power-off state).

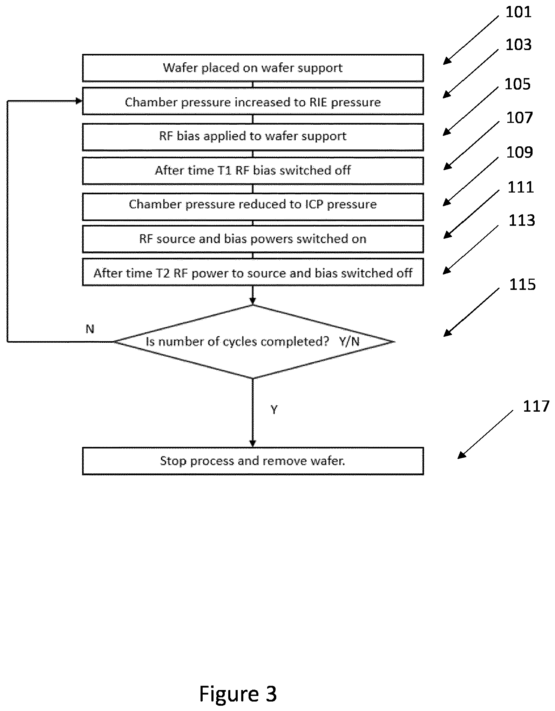

At this time, the controller determines 115 whether the required number of loops have been carried out to achieve the desired degree of SiC wafer surface treatment. As shown in Figure 3, when the required number of loops have been carried out, the process stops, otherwise, the process continues to cycle between etching in the RIE and RIE-assisted ICP modes. Alternatively, the process could terminate after an in situ measurement of surface roughness indicates acceptable smoothing.

At the end of the process, the workpiece is removed 117 from the chamber under vacuum by the transfer robot.

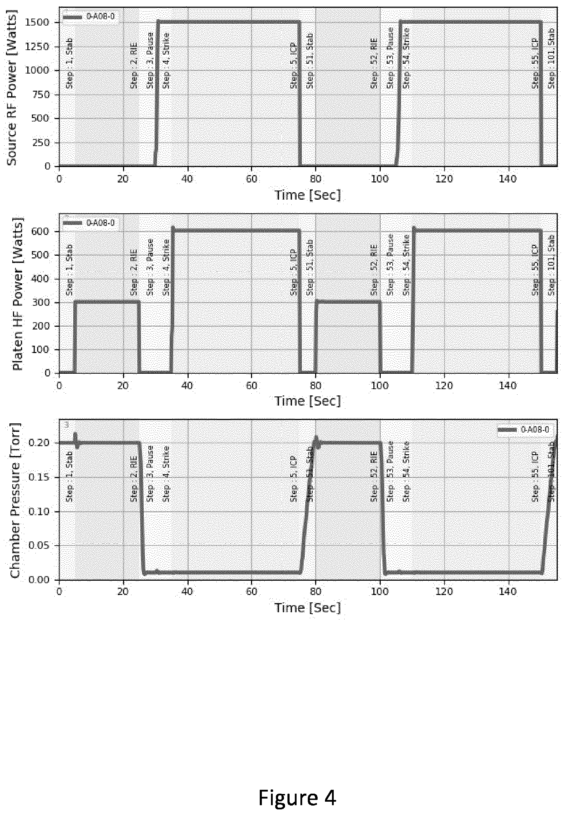

An example etching cycle is shown in Figure 4, with a first duration of time (i.e. for the RIE etch) of about ~20 seconds, and a second duration of time (i.e. for the ICP etch) to ~45 seconds, there being intermediate periods of about ~5 seconds between wherein the chamber pressure is adjusted.

Experiments were performed following the above described method setting a first duration of time (i.e. for the RIE etch) to ~10 seconds, and a second duration of time (i.e. for the ICP etch) to ~50 seconds. The experiments were conducted at room temperature (i.e. a platen temperature of approximately 20 degrees Celsius). The Rq and Ra roughness of the samples were measured at a variety of scales (1x1µm², 10x10µm² and 40x40µm²) by Atomic Force Microscopy using noncontact scanning mode operation (Park Systems XE7 AFM). The surface roughness changes are shown in Table 1 below for two test wafers with initial Ra of 25nm and 1.1nm.

Also shown in Table 1 are the comparable surface roughness changes reported for a number of test processes: an ICP-alone process including a 10 minute pre-etch Argon warm/ surface treatment, and a RIE followed by ICP process.

The ICP-alone process parameters were chamber pressure of 2-10 mTorr, source RF power of ~1500 W (in the range of 1000-3000 W) with bias RF power to the substrate support of ~600 W (in the range of 300-1000 W). Gas flows were unchanged at ~50 sccm (SF₆), 15 sccm (O₂) and 100 sccm (He).

The RIE process parameters were chamber pressure of ~200 mTorr (in the range of 100-300 mTorr) and bias RF power of ~300 W (in the range of 100-500 W). Gas flows were unchanged at ~50 sccm (SF₆), ~15 sccm (O₂) and ~100 sccm (He).

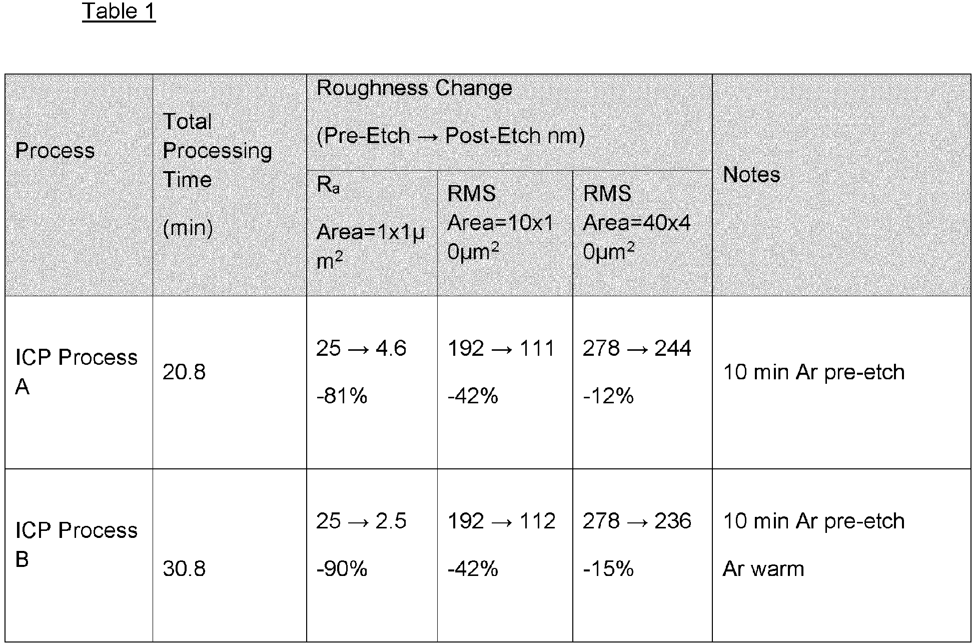

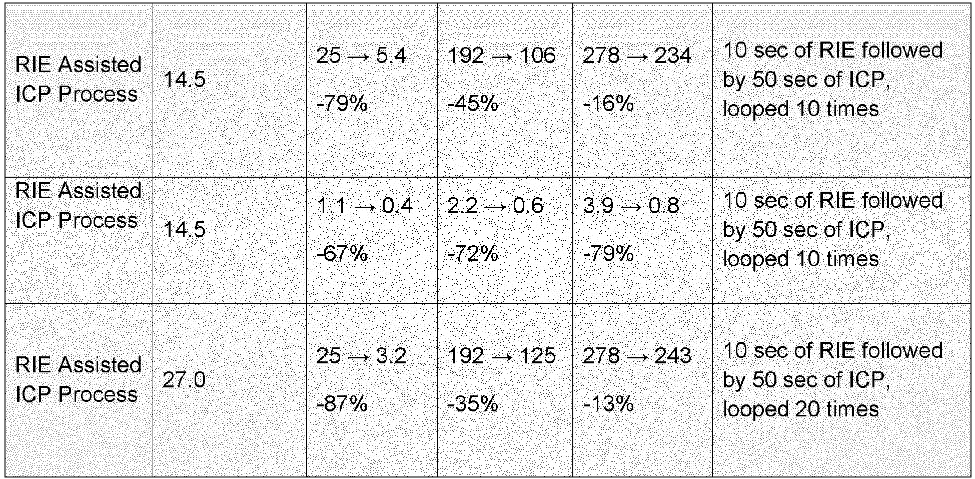

It is known to utilize a pre-etch step to clean/ warm the material to be etched. Using a pre-etch Ar plasma can help with reducing high frequency roughness. However, it was found that the presently claimed process did not benefit from a pre-etch Ar plasma step, and therefore, similar smoothing results can be achieved with a faster process. Time is required to switch between operating modes, so the full 10 minutes cannot be saved, however, in the cases shown below in Table 1, a 30% reduction in process time could be achieved when using a method in accordance with embodiments of the invention. Alternatively, the smoothing time can be extended to achieve a smoother surface.

The pre-etch step was conducted at a pressure of 10 mTorr using argon, with a source RF power of 2kW and a bias RF power of 0-800 W, immediately prior to the SF₆/O₂/He smoothing process.

In certain methods of the prior art, platen temperature was found to be critical for smoothing e.g. in Osipov et al,. between 15°C and 50°C Rms roughness of the etch front increased from 7.4nm to 112.2nm. We speculate that the high power densities used by Osipov et al, i.e. 1kW source RF for a 4x4cm sample (~62.5W/cm²) results in damage to the etched surface. By operating at lower power densities, 5.7W/cm² - 17W/cm² and diluting the SF₆ and O₂ with He, the process is far less sensitive to the lower platen temperatures. As a result, the present process does not display deterioration in surface smoothing performance when increasing the platen temperature to 50°C.

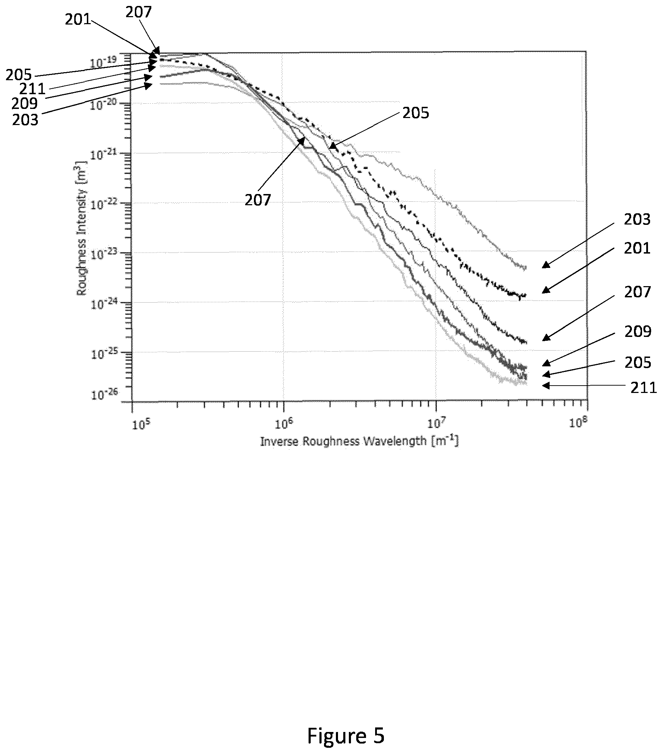

Figure 5 shows the power spectral density data for the different processes, showing roughness intensity vs inverse roughness wavelength. A first line 201 shows the initial workpiece power spectral density. Improvements in surface roughness are indicated by a spectrum below this line. A second line 203 indicates the 20 minute RIE process (including the 10 minute pre-etch Argon warm). Above an inverse wavelength of ~2x10⁶ m⁻¹ the intensity is higher than the control indicating that the sample is becoming rougher in this regime. A third line 205 indicates the 20 minute ICP only process (including the 10 minute pre-etch Argon warm). Surface roughness is significantly improved until we reach an inverse wavelength of ~5x10⁶m⁻¹ or below where the surface roughness degrades. A fourth line 207 shows the 10 minute RIE followed by 10 minute ICP process. The results are inferior to the ICP only process. A fifth line 209 indicates, in accordance with embodiments of the invention, a cyclical RIE and ICP process using a first and second time periods for each cycle of 10 seconds and 50 seconds over a period of 10 cycles. A sixth line 211 indicates the same process over 20 cycles. Both of these processes demonstrate significant improvements in surface roughness especially for inverse roughness values above 1x10⁶ m⁻¹.

The use of He as opposed to a heavier inert gas such as Ar was examined. Using the same SF₆ and O₂ flows as the standard process and replacing He with 100 sccm Ar resulted in a degradation in all scanned areas. Using 25nm initial Ra wafers the changes were -75% (1x1 mm2), -25% (10x10 mm2) and +30% (40x40 mm2). It is thought that the increased sputtering from the heavier ion increases surface roughness. Using He in accordance with the invention helps to dilute the chemical etching components and minimize isotropic etching pits.

The duration of the process will depend on the incoming wafer surface roughness and the specified final surface roughness. As can be seen in Table 1, the change in roughness for wafer coupon with an Ra of 25nm and 1.1nm using the same RIE assisted ICP process result in different changes in roughness. To achieve a <1nm surface roughness with an incoming wafer with 25nm will require more than 29 minutes as the wafer needs to smoothed from 5.4nm to 1.1nm.

## Claims

1. A method of plasma etching a workpiece, the method comprising the steps of:
placing the workpiece upon a substrate support within a plasma chamber, wherein the workpiece comprises a SiC substrate;
introducing SF₆, O₂ and He process gases into the plasma chamber;
plasma etching the SiC substrate to thereby reduce surface roughness of the SiC substrate by alternating between:
(i) applying a bias RF power to the substrate support to generate a reactive-ion etching plasma in the plasma chamber, and etching the SiC substrate at a first plasma chamber pressure for a first period of time; and
(ii) applying a source RF power to the plasma chamber to generate an inductively coupled plasma in the plasma chamber and applying a bias RF power to the substrate support, and etching the SiC substrate at a second plasma chamber pressure for a second period of time.

2. A method according to claim 1, wherein the first plasma chamber pressure is over an order of magnitude greater than the second plasma chamber pressure.

3. A method according to any preceding claim, wherein the first plasma chamber pressure is between 100-400 mTorr, for example about 200 mTorr.

4. A method according to any preceding claim, wherein the second plasma chamber pressure is between 2-10 mTorr, for example about 5 mTorr.

5. A method according to any preceding claim, wherein the second period of time is greater than the first period of time.

6. A method according to any preceding claim, wherein the first period of time is between 5-60 seconds, for example between 10-20 seconds; and/or wherein the second period of time is between 20-120 seconds, for example between 40-50 seconds.

7. A method according to any preceding claim, wherein during the plasma etching, the substrate support is maintained at a temperature between 10-50 degrees Celsius, optionally, wherein during the plasma etching, the substrate support is maintained at a temperature between 15-25 degrees Celsius.

8. A method according to any preceding claim, wherein during step (ii) the source RF power is in the range of 1000-3000 W; and/or wherein during step (i) the bias RF power is in the range of 100-500 W; and/or
wherein during step (ii) the bias RF power is in the range of 300-1000 W.

9. A method according to any preceding claim, wherein there is a pause when looping between steps (i) and (ii) during which time the plasma chamber pressure is adjusted between the first and second plasma chamber pressures, whilst nil source RF power and bias RF power is applied, optionally wherein the pause is for 3-7 seconds.

10. A method according to any preceding claim, wherein during step (ii), the bias RF power is applied 3-7 seconds after the source RF power is applied.

11. A method according to any preceding claim, wherein the SF₆, O₂ and He process gases are introduced to the plasma chamber at flow rates respectively between 40-60 sccm, 10-20 sccm and 90-110 sccm.

12. A method according to any preceding claim, wherein, prior to introducing SF₆, O₂ and He process gases into the plasma chamber, introducing Ar gas into the plasma chamber and applying a bias RF power to the substrate support to generate a reactive-ion etching plasma in the plasma chamber.

13. A method according to any preceding claim, wherein during step (i) applying a nil source RF power or a source RF power of less than 500 Watts.

14. An inductively coupled plasma apparatus for plasma etching a workpiece, the apparatus comprising:
a plasma chamber;
a platen assembly disposed within the plasma chamber configured to receive the workpiece, wherein the workpiece comprises a SiC substrate;
a gas delivery system for introducing process gases into the plasma etch chamber;
a plasma generation device for sustaining a plasma within the plasma chamber for etching the SiC substrate;
a controller configured to control the apparatus to perform a plasma etch of the SiC substrate to thereby reduce surface roughness of the SiC substrate by alternating between the steps of:
(i) applying a bias RF power to the substrate support to generate a reactive-ion etching plasma in the plasma chamber whilst applying a nil source RF power, and etching the SiC substrate at a first plasma chamber pressure for a first period; and
(ii) applying a source RF power to the plasma chamber to generate an inductively coupled plasma in the plasma chamber and applying a bias RF power to the substrate support, and etching the SiC substrate at a second plasma chamber pressure for a second period.

15. A method of plasma etching a workpiece, the method comprising the steps of:
placing the workpiece upon a substrate support within a plasma chamber, wherein the workpiece comprises a SiC substrate;
introducing SF₆, O₂ and He process gases into the plasma chamber;
applying a source RF power to the plasma chamber to generate an inductively coupled plasma in the plasma chamber;
applying a bias RF power to the substrate support; and
plasma etching the SiC substrate to thereby reduce surface roughness of the SiC substrate.
